# EUROPEAN PATENT APPLICATION

(11) **EP 4 141 935 A1**
(43) Date of publication of application: **01.03.2023**
(21) Application number: 21797493.0
(22) Date of filing: 27.04.2021
(51) Int. Cl.: H01L 27/12, H04M 1/02, G09G 3/3225, H01L 27/32, H01L 29/786

(54) **ELECTRONIC DEVICE COMPRISING SENSOR**

(30) Priority: 27.04.2020 KR 20200050967
(71) Applicant: Samsung Electronics Co., Ltd., Suwon-si, Gyeonggi-do 16677 (KR)
(72) Inventor: JO, Jeonggyu, Suwon-si, Gyeonggi-do 16677 (KR); PARK, Hyeongsoon, Suwon-si, Gyeonggi-do 16677 (KR); SIM, Hyunwoo, Suwon-si, Gyeonggi-do 16677 (KR)
(74) Representative: HGF
(86) International application number: PCT/KR2021/005284
(87) International publication number: WO 2021/221422

(57) **Abstract**

An electronic device may comprise a display panel and a sensor. The display panel may be placed within an internal space of a housing in such a way that the display panel can be seen from the outside. The sensor may be positioned below the display panel. The display panel may comprise a first region and a second region according to the position of the sensor. The display panel may comprise a first pixel circuit driving a first pixel positioned in the first region, and a second pixel circuit driving a second pixel positioned in the second region. At least a portion of a plurality of first switching elements included in the first pixel circuit and a plurality of second switching elements included in the second pixel circuit may have different energy band gaps.

## Description

### [Technical Field]

Various embodiments of the disclosure relate to an electronic device including a sensor.

### [Background Art]

Electronic devices, for example, portable electronic devices, are released in various sizes according to the functions and preferences of users and may include a large-screen touch display for securing wide visibility and convenient control. An electronic device may include at least one image sensor (e.g., a camera module), a proximity sensor, or a fingerprint sensor. For example, an electronic device may include at least one image sensor (e.g., a camera module) disposed around a display or through at least a part of the display.

### [Disclosure of Invention]

### [Technical Problem]

An organic light emitting diode (OLED) panel and multiple sensors are applied to an electronic device. A mobile device may include a display, and an image sensor (e.g., a camera module), a proximity sensor, or a fingerprint sensor may be disposed under a display panel. When the fingerprint sensor is disposed under the panel of the display, in some layers (e.g., adhesive and PET layers) constituting a display, a corresponding part is perforated. For example, in some layers (e.g., a PET layer and/or an adhesive layer) on a rear surface of a display panel, a part on which a fingerprint sensor is disposed may be perforated. Accordingly, an area in which the fingerprint sensor is disposed may be externally shown darker than other areas.

A driving circuit unit for emitting light from pixels may include multiple low-temperature polycrystalline silicon (LTPS) thin film transistors (TFTs). When a proximity sensor emits light, a photoelectric effect occurs in a part in which the proximity sensor is disposed, and a leakage current may flow since each of the LTPS TFTs of the driving circuit has a threshold voltage approximately lower by 1.11 eV. When the leakage current flows through the LTPS TFTs, an OLED of the corresponding pixel may unintentionally emit light.

Alternatively, due to the reflection of external light by a fingerprint sensor and/or an air gap, a leakage current may flow around LTPS TFTs of a driving circuit, which may cause an OLED of the corresponding pixel to unintentionally emit light.

According to various embodiments of the disclosure, a driving circuit unit for emitting light from pixels of a display may be composed of oxide TFTs each having a high energy band gap, thereby preventing a leakage current. The flow of the leakage current through TFTs of a driving circuit is prevented, whereby unintended light emission of an OLED and/or a luminance change of the OLED can be prevented.

### [Solution to Problem]

An electronic device according to various embodiments of the disclosure may include a display panel and a sensor. The display panel may be disposed in an inner space of a housing to be visible from the outside. The sensor may be positioned under the display panel. The display panel may include a first area and a second area according to an arrangement of the sensor. The display panel may include a first pixel circuit configured to drive a first pixel disposed in the first area and a second pixel circuit configured to drive a second pixel disposed in the second area. At least a part of multiple first switching elements included in the first pixel circuit may have an energy band gap different from an energy band gap of multiple second switching elements included in the second pixel circuit.

In the electronic device, an entirety of the multiple first switching elements may have an energy band gap different from an energy band gap of an entirety of the multiple second switching elements.

In the electronic device, at least a part of the multiple first switching elements and at least a part of the multiple second switching elements may have an identical energy band gap.

In the electronic device, the energy band gap of the multiple second switching elements may be higher than an energy band gap of a part or an entirety of the multiple first switching elements.

In the electronic device, at least one of the multiple first switching elements may be a low-temperature polycrystalline silicon (LTPS) thin film transistor (TFT), and the multiple second switching elements may be oxide TFTs.

In the electronic device, the multiple first switching elements may include at least n oxide TFTs and the multiple second switching elements may include m oxide TFTs, wherein m is larger than n.

In the electronic device, the oxide TFT may have an energy band gap of 2.5 - 5.0 [eV].

In the electronic device, the oxide TFT may be an IGZO oxide TFT including indium (In), gallium (Ga), zinc (Zo), and oxygen (O).

In the electronic device, at least two of the multiple first switching elements may be oxide TFTs, and at least seven of the multiple second switching elements may be oxide TFTs.

In the electronic device, the second area may be formed to have a range wider than the sensor.

In the electronic device, the sensor may include one or more of a proximity sensor, a fingerprint sensor, and an image sensor.

In the electronic device, the second area may include at least one of a proximity sensor area in which the proximity sensor is disposed, a fingerprint sensor area in which the fingerprint sensor is disposed, and a camera area in which the image sensor is disposed.

In the electronic device, a resin layer may be disposed between the display panel and the proximity sensor, a resin layer may be disposed between the display panel and the fingerprint sensor, or a resin layer may be disposed between the display panel and the image sensor.

In the electronic device, an air gap may be formed between the display panel and the proximity sensor, an air gap may be formed between the display panel and the fingerprint sensor, or an air gap may be formed between the display panel and the image sensor.

The electronic device may include a first gate driver circuit, a second gate driver circuit, and a driver controller. The first gate driver circuit may drive the first pixel disposed in the first area of the display panel. The second gate driver circuit may drive the second pixel disposed in the second area. The driver controller may supply a first gate control signal to the first gate driver circuit and supply a second gate control signal to the second gate driver circuit.

In the electronic device, the first gate driver circuit may generate first shift register signals, based on a first gate control signal input from the driver controller and may supply the first shift register signals to the first pixel circuit. The second gate driver circuit may generate second shift register signals, based on a second gate control signal input from the driver controller, and supply the second shift register signals to the second pixel circuit.

An electronic device according to various embodiments of the disclosure may include a display panel, multiple sensors, and a driving part. The display panel may be disposed in an inner space of a housing to be visible from the outside and may include a first area and multiple second areas except for the first area. The multiple sensors may be positioned under the multiple second areas. The driving part may drive the display panel.

In the electronic device, the multiple sensors may include at least one sensor disposed under the display panel. The display panel may include multiple first switching elements included in multiple first pixel circuits disposed in the first area, and multiple second switching elements included in multiple second pixel circuits disposed in the multiple second areas. The multiple first switching elements may include different types of switching elements having different energy band gaps. The multiple second switching elements may include the same type of switching elements having the same energy band gap.

In the electronic device, at least a part of the multiple first switching elements included in the first pixel circuit may have an energy band gap different from an energy band gap of the multiple second switching elements included in the second pixel circuit.

In the electronic device, the energy band gap of the multiple second switching elements may be higher than an energy band gap of the multiple first switching elements.

In the electronic device, at least one of the multiple first switching elements may be a low-temperature polycrystalline silicon (LTPS) thin film transistor (TFT), and the multiple second switching elements may be oxide TFTs.

### [Advantageous Effects of Invention]

According to various embodiments of the disclosure, a driving circuit unit for emitting light from pixels of a display may be composed of oxide TFTs each having a high energy band gap, thereby preventing a leakage current. The flow of the leakage current through TFTs of a driving circuit is prevented, whereby unintended light emission of an OLED and/or a luminance change of the OLED can be prevented.

Various other effects directly or indirectly identified through the document can be provided.

### [Brief Description of Drawings]

FIG. 1 is a block diagram of an electronic device in a network environment according to various embodiments.
FIG. 2 is a block diagram of a display device according to various embodiments.
FIG. 3 is a front perspective view of a mobile electronic device according to various embodiments of the disclosure.
FIG. 4 is a rear perspective view of the electronic device in FIG. 1 according to various embodiments of the disclosure.
FIG. 5 is an exploded perspective view of an electronic device according to various embodiments of the disclosure.
FIG. 6 is a view showing that multiple sensors are arranged in an electronic device according to various embodiments of the disclosure.
FIG. 7 is a view showing a display panel and a panel driving part of an electronic device according to various embodiments of the disclosure.
FIG. 8A is a view showing one first pixel in a first area (e.g., a display area) of a display according to various embodiments of the disclosure.
FIG. 8B is a view showing one second pixel in a second area (e.g., a sensor area) of a display according to various embodiments of the disclosure.
FIG. 9 is a view showing that a proximity sensor (e.g., an IR sensor) is applied to an electronic device according to various embodiments of the disclosure.
FIG. 10A is a view showing a cross-sectional structure of a display panel on which a top gate type oxide TFT is disposed.
FIG. 10B is a view showing a cross-sectional structure of a display panel on which a bottom gate type oxide TFT is disposed.
FIG. 11 is a view showing that a fingerprint sensor is applied to an electronic device according to various embodiments of the disclosure.
FIG. 12 is a view showing that a fingerprint sensor is applied to an electronic device according to various embodiments of the disclosure.
FIG. 13 is a view showing that a fingerprint sensor is applied to an electronic device according to various embodiments of the disclosure.

In connection with descriptions of the drawings, same or similar reference numerals will be used to refer to same or similar elements.

### [Best Mode for Carrying out the Invention]

Hereinafter, various embodiments of the disclosure will be described with reference to the accompanying drawings. The size of elements illustrated in the drawings may be exaggerated or reduced for the convenience of explanation, and the content disclosed in the document is not necessarily limited to what is illustrated herein.

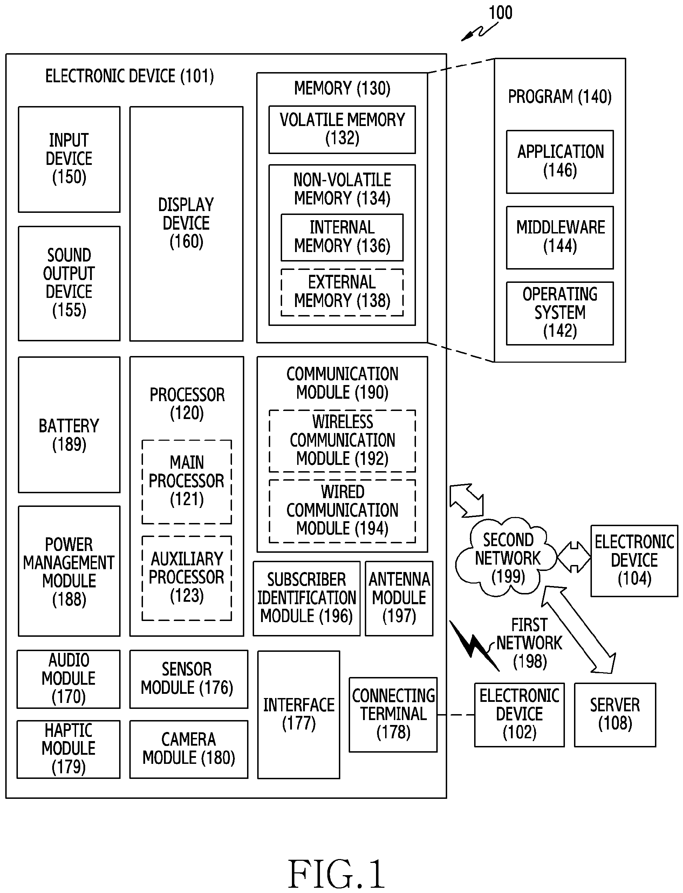

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

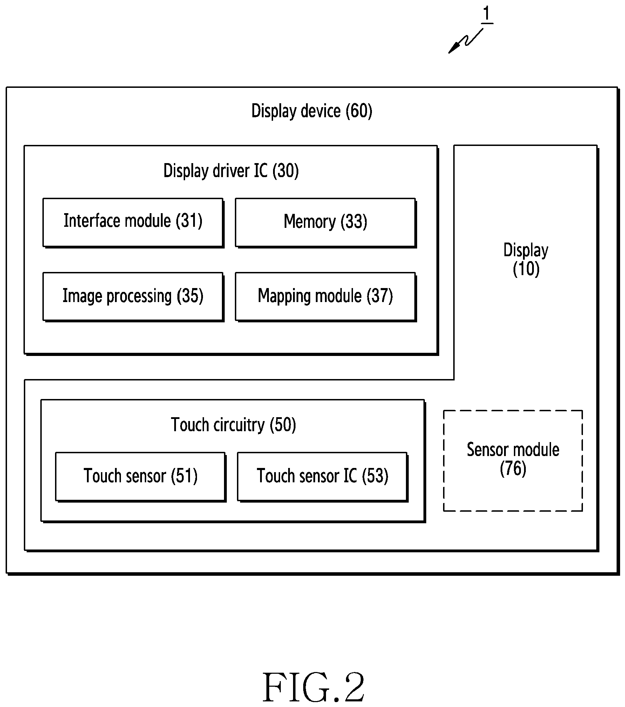

FIG. 2 is a block diagram of a display device according to various embodiments.

Referring to FIG. 2, the display device 60 may include a display 10 and a display driver integrated circuit (DDI) 30 to control the display 10. The DDI 30 may include an interface module 31, memory 33 (e.g., buffer memory), an image processing module 35, or a mapping module 37. The DDI 30 may receive image information that contains image data or an image control signal corresponding to a command to control the image data from another component of the electronic device 101 via the interface module 31. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 30 may communicate, for example, with touch circuitry 50 or the sensor module 76 via the interface module 31. The DDI 30 may also store at least part of the received image information in the memory 33, for example, on a frame by frame basis. The image processing module 35 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 10. The mapping module 37 may generate a voltage value or a current value corresponding to the image data preprocessed or post-processed by the image processing module 35. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 10 may be driven, for example, based at least in part on the voltage value or the current value such that visual information (e.g., a text, an image, or an icon) corresponding to the image data may be displayed via the display 10.

According to an embodiment, the display device 60 may further include the touch circuitry 50. The touch circuitry 50 may include a touch sensor 51 and a touch sensor IC 53 to control the touch sensor 51. The touch sensor IC 53 may control the touch sensor 51 to sense a touch input or a hovering input with respect to a certain position on the display 10. To achieve this, for example, the touch sensor 51 may detect (e.g., measure) a change in a signal (e.g., a voltage, a quantity of light, a resistance, or a quantity of one or more electric charges) corresponding to the certain position on the display 10. The touch circuitry 50 may provide input information (e.g., a position, an area, a pressure, or a time) indicative of the touch input or the hovering input detected via the touch sensor 51 to the processor 120. According to an embodiment, at least part (e.g., the touch sensor IC 53) of the touch circuitry 50 may be formed as part of the display 10 or the DDI 30, or as part of another component (e.g., the auxiliary processor 123) disposed outside the display device 60.

According to an embodiment, the display device 60 may further include at least one sensor (e.g., a fingerprint sensor, an iris sensor, a pressure sensor, or an illuminance sensor) of the sensor module 76 or a control circuit for the at least one sensor. In such a case, the at least one sensor or the control circuit for the at least one sensor may be embedded in one portion of a component (e.g., the display 10, the DDI 30, or the touch circuitry 50)) of the display device 60. For example, when the sensor module 76 embedded in the display device 60 includes a biometric sensor (e.g., a fingerprint sensor), the biometric sensor may obtain biometric information (e.g., a fingerprint image) corresponding to a touch input received via a portion of the display 10. As another example, when the sensor module 76 embedded in the display device 60 includes a pressure sensor, the pressure sensor may obtain pressure information corresponding to a touch input received via a partial or whole area of the display 10. According to an embodiment, the touch sensor 51 or the sensor module 76 may be disposed between pixels in a pixel layer of the display 10, or over or under the pixel layer.

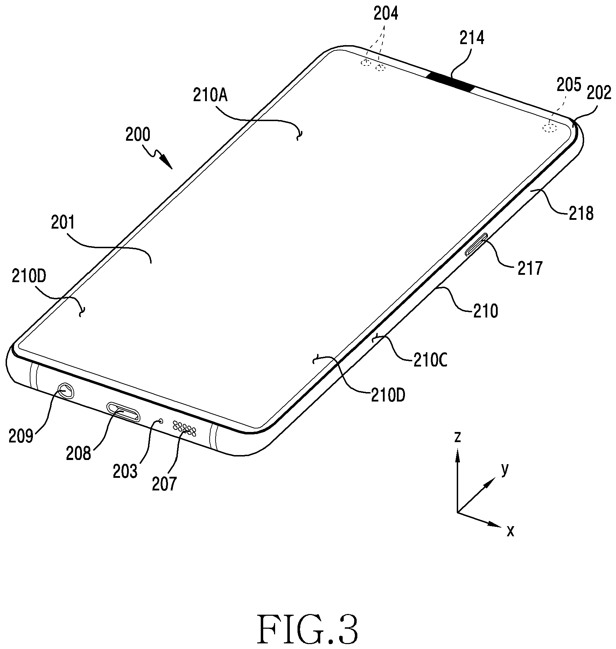

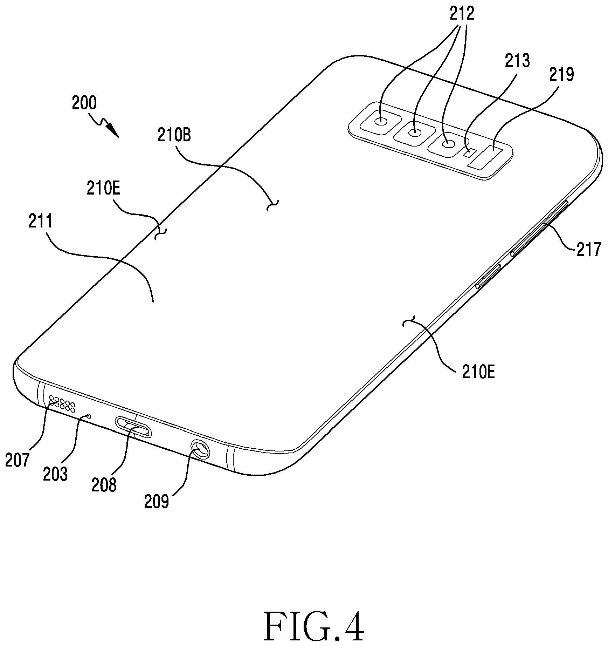

FIG. 3 is a front perspective view of an electronic device 200 (e.g., the electronic device 101 in FIG. 1) according to various embodiments of the disclosure. FIG. 4 is a rear perspective view of an electronic device 200 according to various embodiments of the disclosure.

Referring to FIG. 3 and FIG. 4, the electronic device 200 (e.g., the electronic device 101 in FIG. 1) according to an embodiment may include a first surface (or a front surface) 210A, a second surface (or a rear surface) 210B, and a housing 210 including a side surface 210C surrounding a space between the first surface 210A and the second surface 210B. In another embodiment (not shown), a housing may be referred to as a structure forming a part of the first surface 210A, the second surface 210B, and the side surface 210C. According to an embodiment, the first surface 210A may be formed by a front plate 202 (e.g., a glass plate including various coating layers, or a polymer plate) of which at least a portion is substantially transparent. The second surface 210B may be formed by a substantially opaque rear plate 211. For example, the rear plate 211 may be formed by coated or colored glass, ceramic, polymer, metal (e.g., aluminum, stainless steel (STS), or magnesium), or a combination of at least two of the above materials. The side surface 210C may be coupled to the front plate 202 and the rear plate 211, and may be formed by a side bezel structure 218 (or a "side member") including metal and/or polymer. In some embodiments, the rear plate 211 and the side bezel structure 218 may be integrally formed, and may include the same material (e.g., a metal material such as aluminum).

In the illustrated embodiment, the front plate 202 may include two first areas 210D which are provided at opposite ends of the long edge of the front plate 202 and bent from the first surface 210A toward the rear plate 211 so as to extend seamlessly. In the illustrated embodiment (see FIG. 4), the rear plate 211 may include two second areas 210E which are provided at opposite ends of the long edge thereof and bent from the second surface 210B toward the front plate 202 so as to extend seamlessly. In some embodiments, the front plate 202 (or the rear plate 211) may include only one of the first areas 210D (or the second areas 210E). In some embodiments, a part of the first areas 210D or the second areas 210E may not be included therein. In the embodiments, when seen from the side surface of the electronic device 200, the side bezel structure 218 may have a first thickness (or width) in the side of the side surface, in which the first regions 210D or the second regions 210E are not included, and may have a second thickness thinner than the first thickness, in the side of the surface side, in which the first regions 210D or the second regions 210E are included.

According to an embodiment, the electronic device 200 may include at least one of a display 201 (e.g., the display 10 in FIG. 2), an input device 203, sound output devices 207 and 214, sensor modules 204 and 219, camera modules 205, 212, and 213, a key input device 217, an indicator (not shown), and connectors 208 and 209. In some embodiments, at least one (e.g., the key input device 217 or the indicator) of the elements may be omitted from the electronic device 200, and other elements may be additionally included therein.

For example, the display 201 may be exposed through the upper end portion of the front plate 202. In some embodiments, at least a part of the display 201 may be exposed through the front plate 202 forming the first surface 210A and the first areas 210D of the side surface 210C. The display 201 may be coupled or adjacently disposed to a touch detection circuit, a pressure sensor capable of measuring the intensity (pressure) of touch, and/or a digitizer for detecting a magnetic field-type stylus pen. In some embodiments, at least a part of the sensor module 204 or 219, and/or at least a part of the key input device 217 may be disposed in the first areas 210D and/or the second areas 210E.

In some embodiments (not shown), at least one of an audio module 214, the sensor module 204, the camera module 205 (e.g., an image sensor), and a fingerprint sensor may be included on the rear surface of a screen display area of the display 201. In some embodiments (not shown), the display 201 may be coupled or adjacently disposed to a touch detection circuit, a pressure sensor capable of measuring the intensity (pressure) of touch, and/or a digitizer for detecting a magnetic field-type stylus pen. In some embodiments, at least a part of the sensor module 204 or 219 and/or at least a part of the key input device 217 may be disposed in the first areas 210D and/or the second areas 210E.

The input device 203 may include a microphone. In some embodiments, the input device 203 may include multiple microphones arranged to be able to detect the direction of sound. The sound output devices 207 and 214 may include speakers 207 and 214. The speakers 207 and 214 may include an external speaker 207 and a receiver (e.g., the audio module 214) for calls. In some embodiments, the input device 203 (e.g., a microphone), the speakers 207 and 214, and the connectors 208 and 209 may be arranged in the space of the electronic device 200, and may be exposed to an external environment through at least one hole formed through the housing 210. In some embodiments, the hole formed through the housing 210 may be used in common for the input device 203 (e.g., a microphone) and the speakers 207 and 214. In some embodiments, the speakers 207 and 214 may include a speaker (e.g., a piezo speaker) which is operated in a state where a hole formed through the housing 210 is excluded.

The sensor modules 204 and 219 may generate an electrical signal or a data value corresponding to an internal operation state of the electronic device 200 or an external environmental state. For example, the sensor modules 204 and 219 may include a first sensor modules 204 (e.g., a proximity sensor) and/or a second sensor module (not shown) (e.g., a fingerprint sensor) arranged on the first surface 210A of the housing 210, and/or a third sensor module 219 (e.g., an HRM sensor) disposed on the second surface 210B of the housing 210. The fingerprint sensor may also be disposed on the first surface 210A (e.g., the display 201) and/or the second surface 210B of the housing 210. The electronic device 200 may further include a sensor module not illustrated, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera module 205 disposed on the first surface 210A of the electronic device 200, and a second camera module 212 and/or a flash 213 arranged on the second surface 210B. The camera modules 205 and 212 each may include one lens or multiple lenses, an image sensor, and/or an image signal processor. For example, the flash 213 may include a light-emitting diode or a xenon lamp. The first camera module 205 may be disposed under a display panel in an under-display camera (UDC) manner. In some embodiments, two or more lenses (a wide-angle and a telephoto lens) and image sensors may be arranged on one surface of the electronic device 200. In some embodiments, the multiple first camera modules 205 may be arranged on the first surface (e.g., the surface on which the screen is displayed) of the electronic device 200 in an under-display camera (UDC) manner.

The key input device 217 may be disposed on the side surface 210C of the housing 210. In another embodiment, the electronic device 200 may not include a part or the whole of the key input device 217 mentioned above, and the key input device 217 not included therein may be implemented as a different type such as a soft key, on the display 201. In some embodiments, the key input device 217 may be implemented using a pressure sensor included in the display 201.

For example, the indicator may be disposed on the first surface 210A of the housing 210. For example, the indicator may provide state information of the electronic device 200 in the form of light. In another embodiment, for example, the indicator may provide a light source interlocked with an operation of the camera module 205. For example, the indicator may include an LED, an IR LED, or a xenon lamp.

The connectors 208 and 209 may include a first connector hole 208 capable of accommodating a connector (for example, a USB connector) for transmitting or receiving power and/or data to or from an external electronic device, and/or a second connector hole 209 (or an earphone jack) capable of accommodating a connector for transmitting or receiving an audio signal to or from an external electronic device.

A camera module 205 of the camera modules 205 and 212, a sensor module 204 of the sensor modules 204 and 219, or the indicator may be arranged to be visible through the display 201. The camera module 205 may be disposed to overlap a display area, and a screen may be displayed also in the display area corresponding to the camera module 205. A sensor module 204 may be disposed to perform the function thereof without being visually exposed through the front plate 202 in the inner space of the electronic device.

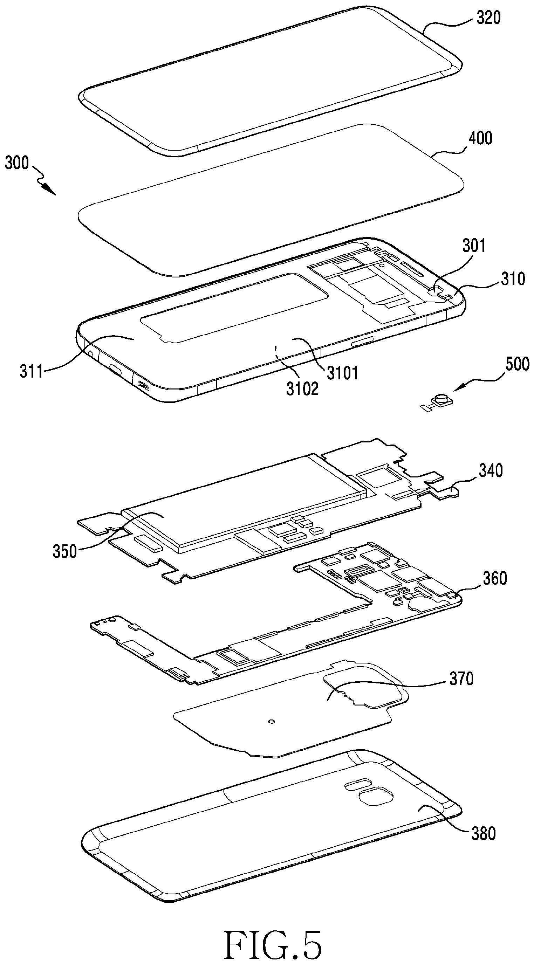

FIG. 5 is an exploded perspective view of an electronic device 300 according to various embodiments of the disclosure.

Referring to FIG. 5, according to various embodiments, an electronic device 300 (e.g., the electronic device 101 in FIG. 1 or the electronic device 200 in FIG. 3) may include a side member 310 (e.g., a side bezel structure), a first support member 311 (e.g., a bracket or a support structure), a front plate 320 (e.g., a front surface cover), a display 400 (e.g., the display device 160 in FIG. 1 or the display 201 in FIG. 3), a printed circuit board 340, a battery 350 (e.g., the battery 189 in FIG. 1), a second support member 360 (e.g., a rear case), an antenna 370 (e.g., the antenna module 197 in FIG. 1), and a rear plate 380 (e.g., the rear cover). In some embodiments, at least one (e.g., the first support member 311 or the second support member 360) of elements may be omitted from the electronic device 300, or other elements may be additionally included therein. At least one of elements of the electronic device 300 may be the same as or similar to at least one of elements of the electronic device 101 in FIG. 1 or the electronic device 200 in FIG. 3, and overlapping descriptions will be omitted hereinafter.

According to various embodiments, the first support member 311 may be disposed inside the electronic device 300 to be connected to the side member 310 or to be integrally formed with the side member 310. For example, the first support member 311 may be formed of a metal material and/or non-metal (e.g., polymer) material. The first support member 311 may have one surface to which the display 330 is coupled, and the other surface to which the printed circuit board 340 is coupled. The printed circuit board 340 may have a processor, a memory, and/or an interface, which are mounted thereon. For example, the processor may include one or more of a central processing device, an application processor, a graphic processing device, an image signal processor, a sensor hub processor, and a communication processor.

For example, the memory may include the volatile memory 132 in FIG. 1 or the non-volatile memory 134 in FIG. 1.

For example, the interface may include a high definition multimedia interface (HDMI), a universal serial bus (USB) interface, an SD card interface, and/or an audio interface. For example, the interface may electrically or physically connect the electronic device 300 to an external electronic device, and may include a USB connector, an SD card/MMC connector, or an audio connector.

For example, the battery 350 (e.g., the battery 189 in FIG. 1) may be a device for supplying power to at least one element of the electronic device 300, and for example, may include a non-rechargeable primary cell, a rechargeable secondary cell, or a fuel cell. For example, at least a part of the battery 350 may be disposed on substantially the same plane as the printed circuit board 340. The battery 350 may be integrally disposed inside the electronic device 300. As another embodiment, the battery 350 may be disposed detachably from the electronic device 300.

For example, the antenna 370 may be disposed between the rear plate 380 and the battery 350. For example, the antenna 370 may include a near field communication (NFC) antenna, a wireless charging antenna, and/or a magnetic secure transmission (MST) antenna. For example, the antenna 370 may perform a short-range communication with an external device, or may transmit or receive power required for charging in a wireless. In another embodiment, an antenna structure may be formed by a part of the first support member 311 and/or the side member 310, or a combination thereof.

According to various embodiments, the first support member 311 of the side member 310 may include a first surface 3101 facing the front plate 320 and a second surface 3102 facing a direction (e.g., the direction of the rear plate) opposite to the first surface 3101. According to some embodiments, the camera module 500 (e.g., the camera module 180 in FIG. 1) may be disposed between the first support member 311 and the rear plate 380. According to some embodiments, the camera module 500 may be disposed to protrude in or to be visible from the direction of the front plate 320 through a through-hole 301 connected from the first surface 3101 to the second surface 3102 of the first support member 311. According to some embodiments, a portion, which protrudes through the through-hole 301 of the camera module 500, may be disposed to detect an external environment at a corresponding position of the display 400. As another embodiment, when the camera module 500 is disposed between the display 400 and the first support member 311, the through-hole 301 may be unnecessary.

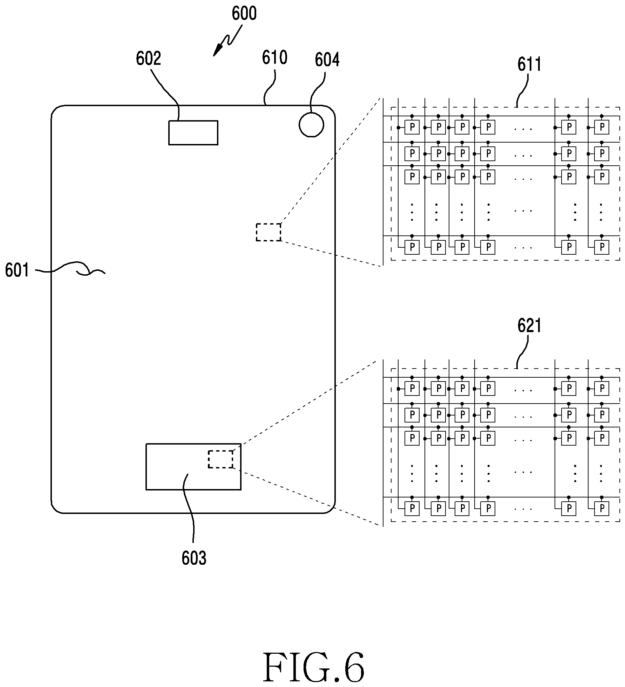

FIG. 6 is a view showing that multiple sensors are arranged in an electronic device 600 according to various embodiments of the disclosure.

Referring to FIG. 6, an electronic device 600 (e.g., the electronic device 101 in FIG. 1, the electronic device 200 in FIG. 3, or the electronic device 300 in FIG. 5) according to various embodiments may include a display panel 610 (e.g., the display 10 in FIG. 2 or the display 400 in FIG. 5) which displays a screen by using multiple OLED pixels, and multiple sensors (e.g., the sensor module 76 in FIG. 1, the camera module 500 in FIG. 5, an image sensor, a proximity sensor (an IR sensor or a UV sensor), and/or a fingerprint sensor) arranged disposed under the display panel 610. According to various embodiments, the display panel 610 may include a display area 601, a proximity sensor area 602 according to an arrangement of a proximity sensor, a fingerprint sensor area 603 according to an arrangement of a fingerprint sensor, a camera area 604 according to an arrangement of a camera. In an example, the display panel 610 may include an OLED panel. A proximity sensor may be disposed under the display panel 610, and a portion, at which the proximity sensor is disposed, may be defined as the proximity sensor area 602. A fingerprint sensor may be disposed under the display panel 610, and a portion, at which the fingerprint sensor is disposed, may be defined as the fingerprint sensor area 603. FIG. 6 illustrates, as an example, that the proximity sensor area 602 is disposed on the upper side part of the display panel 610 and the fingerprint sensor area 603 is disposed on the lower side part of the display panel 610. However, without being limited to the illustrated example, the positions of the proximity sensor area 602 and the fingerprint sensor area 603 may be changed.

According to various embodiments, multiple first pixels 611 may be arranged in the display area 601 of the display panel 610. According to an example, multiple second pixels 621 may be arranged in the proximity sensor area 602 and the fingerprint sensor area 603 also.

As one embodiment, pixel circuits for driving the multiple first pixels 611 may be formed by a low-temperature polycrystalline silicon (LTPS) thin film transistors (TFTs). As one embodiment, pixel circuits for driving the multiple first pixels 611 may be formed by mixing LTPS TFTs and oxide TFTs. As one embodiment, pixel circuits for driving the multiple second pixels 621 may be formed only by oxide (Oxide) TFTs.

According to various embodiments, a through-hole (e.g., the through-hole 301 in FIG. 5) may be formed through the camera area 604, and a camera module (e.g., an image sensor) (e.g., the camera module 500 in FIG. 5) may be disposed to correspond to the through-hole 301. When the camera module is disposed in a through-hole manner, pixels may not be formed through the camera area 604. However, without being limited to the through-hole manner, one or more camera modules (e.g., image sensors) may be arranged under the display panel 610 in an under-display camera (UDC) manner also. When the camera module is disposed under the display panel 610 in the under-display camera manner, multiple third pixels may be arranged in the camera area 604. The multiple third pixels may be arranged in the same form as or a similar form to the multiple second pixels 621.

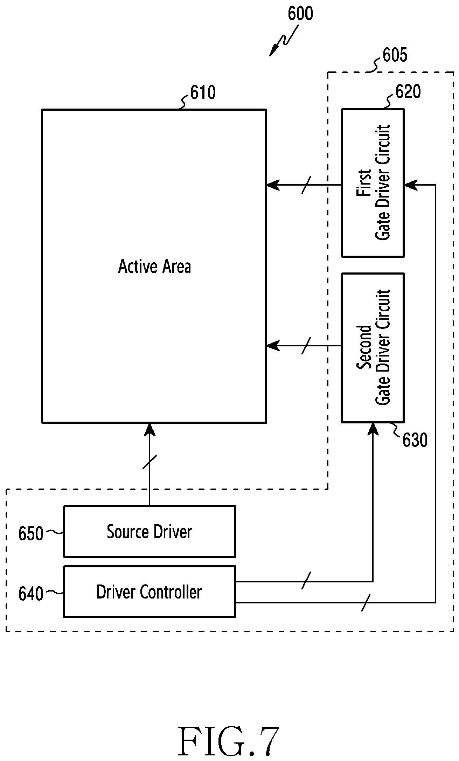

FIG. 7 is a view showing a display panel 610 and a panel driving part of an electronic device 600 according to various embodiments of the disclosure.

Referring to FIG. 7, according to various embodiments, an electronic device 600 may include a panel driving part 605 (or a control circuit) for driving the display panel 610. The panel driving part 605 may include a first gate driver circuit 620 (e.g., an LTPS TFTs gate driver circuit), a second gate driver circuit 630 (e.g., an oxide TFTs gate driver circuit), a driver controller 640, and a source driver 650.

According to various embodiments, the panel driving part 605 may include at least a part of a DDI (e.g., the DDI 30 in FIG. 2) and/or a touch sensor IC (e.g., the touch sensor IC 53 in FIG. 2) which are arranged in a chip on panel (COP) or a chip on film (COF) method.

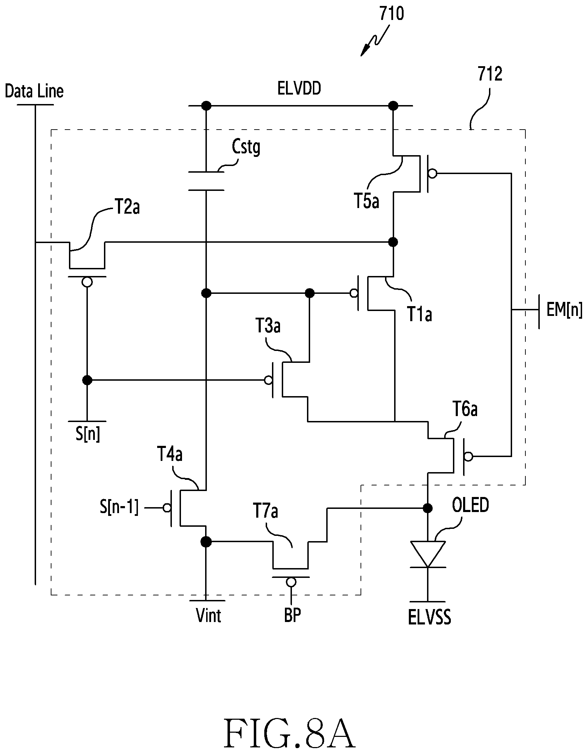

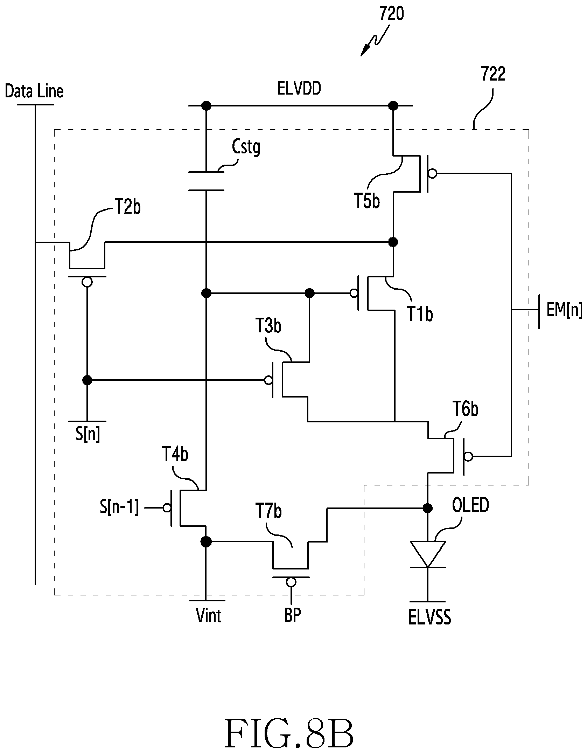

FIG. 8A is a view showing one first pixel 710 in a first area (e.g., the display area 601) of a display according to various embodiments of the disclosure. FIG. 8B is a view showing one second pixel 720 in a second area (e.g., a sensor area) of a display according to various embodiments of the disclosure. Here, the sensor area may include the proximity sensor area 602 or the fingerprint sensor area 603 illustrated in FIG. 6.

Referring to FIG. 6 to FIG. 8B, multiple first pixels (e.g., the first pixels 710 in FIG. 8A) may be arranged in the display area 601 according to various embodiments of the disclosure. Each of the first pixels 710 may include an OLED (e.g., the OLED in FIG. 8A) and a first pixel circuit (e.g., the first pixel circuit 712 in FIG. 8A).

In addition, multiple second pixels (e.g., the second pixels 720 in FIG. 8B) may be arranged in the proximity sensor area 602 and the fingerprint sensor area 603. Each of the second pixels 720 may include an OLED and a second pixel circuit (e.g., the second pixel circuit 722 in FIG. 8B).

According to various embodiments, for example, the first gate driver circuit 620 illustrated in FIG. 7 may include LTPS TFT gate driver circuits. Alternatively, the first gate driver circuit 620 may include multiple oxide TFTs gate driver circuits. Alternatively, the first gate driver circuit 620 may include multiple LTPS TFTs gate driver circuits and multiple oxide TFTs gate driver circuits. The first gate driver circuit 620 may generate first shift register signals, based on a first gate control signal input from the driver controller 640. The first shift register signals may be supplied to at least one first pixel circuit (e.g., the first pixel circuit 712 in FIG. 8A) in order to make at least one OLED (e.g., the OLED in FIG. 8A), which is included in at least one first pixel (e.g., the first pixel 710 in FIG. 8A) disposed in the display area 601, emit light. The first pixel circuit 712 each may include multiple first switching elements T1a - T7a (e.g., multiple LTPS TFTs or a mixture of multiple LTPS TFTs and multiple oxide TFTs). The first shift register signals may be supplied to the first switching elements T1a - T7a. The first switching elements T1a - T7a may be turned on or turned off by the first shift register signals.

According to various embodiments, for example, the second gate driver circuit 630 illustrated in FIG. 7 may include multiple oxide TFTs gate driver circuits. The second gate driver circuit 630 may generate second shift register signals, based on a second gate control signal input from the driver controller 640. The second shift register signals may be supplied to at least one second pixel circuit (e.g., the second pixel circuit 722 in FIG. 8B) in order to make at least one OLED (e.g., the OLED in FIG. 8B), which is included in at least one second pixel (e.g., the second pixel 720 in FIG. 8B) disposed in the proximity sensor area 602 and the fingerprint sensor area 603. The second pixel circuit 722 each may include multiple second switching elements T1b - T7b (e.g., multiple oxide TFTs). The second shift register signals may be supplied to the multiple second switching elements T1b - T7b. The multiple second switching elements T1b - T7b (e.g., multiple oxide TFTs) may be turned on or turned off by the second shift register signals.

According to various embodiments, the driver controller 640 may generate a first gate control signal for driving the first gate driver circuit 620. The driver controller 640 may supply the first gate control signal to the first gate driver circuit 620. In addition, the driver controller 640 may generate a second gate control signal for driving the second gate driver circuit 630. The driver controller 640 may supply the second gate control signal to the second gate driver circuit 630.

According to various embodiments, the source driver 650 may generate a data voltage corresponding to an image signal, and may sequentially supply the data voltage to multiple data lines arranged on the display panel 610. The data voltage, which is supplied to the multiple data lines, may be supplied to the multiple first pixel circuits 720 and the multiple second pixel circuits 722 which are connected to the multiple data lines.

According to various embodiments of the disclosure, the first pixel 710 may include a scan line, a data line, a light-emitting device (e.g., an OLED), and the first pixel circuit 712. The first pixel circuit 712 may be connected to the scan line and the data line. The OLED included in the first pixel 710 may be connected to the first pixel circuit 712.

According to various embodiments of the disclosure, the first pixel circuit 712 each may include one or more capacitors Cstg and multiple first switching elements T1a - T7a. As one embodiment, the first pixel circuit 712 may include a storage capacitor Cstg, a drive TFT T1a, a switching TFT T2a, a compensation TFT T3a, a first initialization TFT T4a, a first light-emitting control TFT T5a, a second light-emitting control TFT T6a, and a second initialization TFT T7a. FIG. 8A illustrates, as an example, that one first pixel circuit 712 is formed by one capacitor Cstg and seven switching elements T1a - T7a. However, without being limited to the illustrated example, the number of capacitors and switching elements constituting one first pixel circuit 712 may be changed according to a driving manner.

According to various embodiments of the disclosure, the second pixel 720 may include a scan line, a data line, a light-emitting device (e.g., an OLED), and the second pixel circuit 722. The second pixel circuit 722 may be connected to the scan line and the data line. The OLED included in the second pixel 720 may be connected to the second pixel circuit 722.

According to various embodiments of the disclosure, the second pixel circuit 722 each may include one or more capacitors Cstg and multiple second switching elements T1b - T7b. As one embodiment, the second pixel circuit 722 may include a storage capacitor Cstg, a drive TFT T1b, a switching TFT T2b, a compensation TFT T3b, a first initialization TFT T4b, a first light-emitting control TFT T5b, a second light-emitting control TFT T6b, and a second initialization TFT T7b.

FIG. 8B illustrates, as an example, that one second pixel circuit 722 is formed by one capacitor Cstg and seven switching elements T1b - T7b. However, without being limited to the illustrated example, the number of capacitors and switching elements constituting one second pixel circuit 722 may be changed according to a driving manner.

According to various embodiments of the disclosure, drain electrodes of the drive TFTs T1a and T1b, which are respectively included in the first pixel circuit 712 and the second pixel circuit 722, may be electrically respectively connected to the OLEDs via a second light-emitting control TFTs T6a and T6b. The drive TFTs T1a and T1b may receive a data signal Dm according to switching operations of the switching TFTs T2a and T2b so as to supply a drive current to the OLEDs, respectively.

According to various embodiments of the disclosure, gate electrodes of the switching TFTs T2a and T2b, which are respectively included in the first pixel circuit 712 and the second pixel circuit 722, may be electrically connected to first scan lines S[n]. Source electrodes of the switching TFTs T2a and T2b may be connected to data lines. The drain electrodes of the switching TFTs T2a and T2b may be connected to the drive TFTs T1a and T1b and the first light-emitting control TFTs T5a and Tb5. The drain electrodes of the switching TFTs T2a and T2b may be connected to drive voltage (ELVDD) lines via the first light-emitting control TFTs T5a and T5b.

According to various embodiments of the disclosure, the second switching TFTs T2a, T2b, which are respectively included in the first pixel circuit 712 and the second pixel circuit 722, may be turned on according to the first scan signals Sn received through the first scan lines, so as to deliver the data signals Dm, which are delivered to the data lines, to source electrodes of the drive TFT T1a and T1b.

According to various embodiments of the disclosure, gate electrodes of the compensation TFTs T3a and T3b, which are respectively included in the first pixel circuit 712 and the second pixel circuit 722, may be connected to the first scan lines S[n]. Source electrodes of the compensation TFTs T3a and T3b may be connected to the drain electrodes of the drive TFTs T1a and T1b. The compensation TFTs T3a and T3b may be connected to the pixel electrodes of the OLEDs via the second light-emitting control TFTs T6a and T6b. Drain electrodes of the compensation TFTs T3a and T3b may be commonly connected to any one electrode of the storage capacitors Cstg, source electrodes of the first initialization TFTs T4a and T4b, and the gate electrodes of the drive TFTs T1a and T1b.

According to various embodiments of the disclosure, the compensation TFTs T3a and T3b, which are respectively included in the first pixel circuit 712 and the second pixel circuit 722, may be turned on according to the first scan signals received through the first scan lines Sn, so as to diode-connect the gate electrodes and the drain electrodes of the drive TFTs T1a and T1b.

According to various embodiments of the disclosure, gate electrodes of the first initialization TFTs T4a and T4b, which are respectively included in the first pixel circuit 712 and the second pixel circuit 722, may be connected to second scan lines Sn-1. Drain electrodes of the first initialization TFTs T4a and T4b may be connected to initialization voltage (Vint) lines. Source electrodes of the first initialization TFTs T4a and T4b may be commonly connected to any one electrode of the storage capacitors Cstg, the drain electrodes of the compensation TFTs T3a and T3b, and the gate electrodes of the drive TFTs T1a and T1b. The first initialization TFTs T4a and T4b may be turned on according to the second scan signals received through the second scan lines Sn-1, so as to deliver the initialization voltages Vint to the gate electrodes of the drive TFTs T1a and T1b. The initialization voltages Vint may be input to the gate electrodes of the drive TFTs T1a and T1b so as to initialize the voltages of the gate electrodes of the drive TFTs T1a and T1b.

According to various embodiments of the disclosure, gate electrodes of the first light-emitting control TFTs T5a and T5b, which are respectively included in the first pixel circuit 712 and the second pixel circuit 722, may be connected to light-emitting control lines EMn. Source electrodes of the first light-emitting control TFTs T5a and T5b may be connected to drive voltage (ELVDD) lines. Drain electrodes of the first light-emitting control TFTs T5a and T5b may be commonly connected to the source electrodes of the drive TFTs T1a and T1b and the drain electrodes of the switching TFTs T2a and T2b.

According to various embodiments of the disclosure, gate electrodes of the second light-emitting control TFTs T6a and T6b, which are respectively included in the first pixel circuit 712 and the second pixel circuit 722, may be connected to light-emitting control lines. Source electrodes of the second light-emitting control TFTs T6a and T6b may be commonly connected to the drain electrodes of the drive TFTs T1a and T1b and the source electrodes of the compensation TFTs T3a and T3b. Drain electrodes of the second light-emitting control TFT T6a and T6b may be electrically connected to pixel electrodes (or anode electrodes) of the OLEDs.

According to various embodiments of the disclosure, the first light-emitting control TFTs T5a and T5b and the second light-emitting control TFTs T6a and T6b may be simultaneously turned on according to light-emitting control signals EM received through the light-emitting control lines such that the drive voltages ELVDD are delivered to the OLEDs. The drive voltages ELVDD are delivered to the OLEDs so that drive currents flow through the OLEDs.

According to various embodiments of the disclosure, gate electrodes of the second initialization TFTs T7a and T7b, which are respectively included in the first pixel circuit 712 and the second pixel circuit 722, may be connected to third scan lines BP. Source electrodes of the second initialization TFTs T7a and T7b may be connected to pixel electrodes of the OLEDs. Drain electrodes of the second initialization TFTs T7a and T7b may be connected to the initialization voltage (Vint) lines. The second initialization TFTs T7a and T7b may be turned on according to third scan signals received through the third scan lines BP, so as to initialize the pixel electrodes (e.g., anode electrodes) of the OLEDs.

According to various embodiments of the disclosure, first electrodes of storage capacitors Cstg, which are respectively included in the first pixel circuit 712 and the second pixel circuit 722, may be connected to the drive voltage (ELVDD) lines. Second electrodes of the storage capacitors Cstg may be commonly connected to the gate electrodes of the drive TFTs T1a and T1b, the drain electrodes of the compensation TFTs T3a and T3b, and the source electrodes of the first initialization TFTs T4a and T4b.

According to various embodiments of the disclosure, counter electrodes (e.g., cathode electrodes) of the OLEDs, which are respectively included in the first pixel circuit 712 and the second pixel circuit 722, may be connected to common power (ELVSS) lines. The OLEDs may receive drive currents from the drive TFTs T1a and T1b, and may emit light having brightness proportional to the drive currents.

Referring to FIG. 6 again, LTPS TFTs may be positioned in the first pixel circuit 712 of the multiple first pixels 710 arranged in the display area 601. Alternatively, a mixture of LTPS TFTs and oxide TFTs may be disposed in the first pixel circuit 712. Here, LTPS TFTs may be applied to a part of TFTs included in the first pixel circuit 712, and oxide TFTs may be applied to the remaining TFTs.

As one embodiment, when the first pixel circuit 712 includes a LTPS TFT, at least a part of the first switching elements T1a - T7a included in the first pixel circuit 712 and an entirety of the second switching elements T1b - T7b included in the second pixel circuit 722 may have different energy band gaps.

As one embodiment, when the first pixel circuit 712 includes a LTPS TFT, an entirety of the first switching elements T1a - T7a included in the first pixel circuit 712 and an entirety of the second switching elements T1b - T7b included in the second pixel circuit 722 may have different energy band gaps.

As one embodiment, when the first pixel circuit 712 includes an oxide TFT, a part of the first switching elements T1a - T7a included in the first pixel circuit 712 and a part or an entirety of the second switching elements T1b - T7b included in the second pixel circuit 722 may have the same energy band gaps.

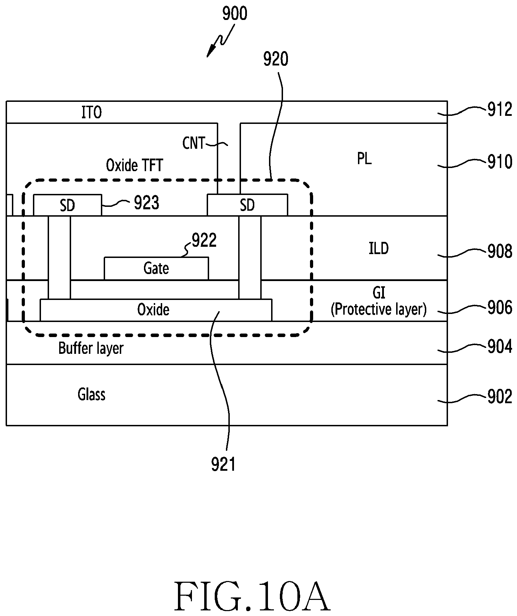

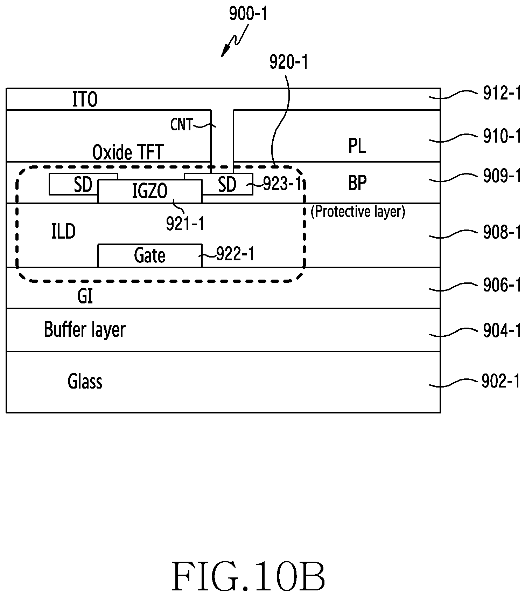

As one embodiment, when the first pixel circuit 712 includes an oxide TFT, an entirety of the first switching elements T1a - T7a included in the first pixel circuit 712 and an entirety of the second switching elements T1b - T7b included in the second pixel circuit 722 may have different energy band gaps. Although the first pixel circuit 712 includes an oxide TFT, a first oxide included in an active layer of the first switching elements T1a - T7a of the first pixel circuit 712 and a second oxide included in an active layer (e.g., the active layer 921 in FIG. 10A or the active layer 921-1 in FIG. 10B) of the second switching elements T1b - T7b included in the second pixel circuit 722 may be different from each other. In this case, the first switching elements T1a - T7a included in the first pixel circuit 712 and the second switching elements T1b - T7b included in the second pixel circuit 722 may have different energy band gaps.

As one embodiment, among the first switching elements T1a - T7a of the first pixel circuit 712, the compensation TFT T3a and the first initialization TFT T4a may be an oxide TFT. As one embodiment, all of the second switching elements T1b - T7b of the second pixel circuit 722 may be oxide TFTs. That is, the drive TFT T1b, the switching TFT T2b, the compensation TFT T3b, the first initialization TFT T4b, the first light-emitting control TFT T5b, the second light-emitting control TFT T6b, and the second initialization TFT T7b may be an oxide TFT.

As one embodiment, at least n switching elements among the multiple first switching elements (TFTs) of the first pixel circuit 712 may be the first oxide TFTs, and the multiple switching elements (TFTs) of the second pixel circuit 722 may include m oxide TFTs, wherein m is larger than n (m > n).

As one embodiment, oxide TFTs may be positioned in the second pixel circuit 722 of the multiple second pixels 720 arranged in the proximity sensor area 602 and the fingerprint sensor area 603. All TFTs included in the second pixel circuit 722 may be formed by an oxide TFT.

Here, the energy band gap of silicon may be 1.10 - 1.20 [eV]. Here, the energy band gap of oxide TFTs may be 2.5 - 5.0 [eV].

According to various embodiments, the multiple first pixel circuits 712 may include multiple LTPS TFTs and multiple oxide TFTs. The multiple second pixel circuits 722 may include multiple LTPS TFTs and multiple oxide TFTs. In this case, the second pixel circuit 722 may be formed to have a ratio of an oxide TFT, which is higher than the ratio of an oxide TFT of the first pixel circuit 712.

According to various embodiments of the disclosure, when a camera is disposed under the display panel 610 in an under-display camera (UDC) manner, multiple third pixel circuits may be arranged in the camera area 604 according to an arrangement of the camera. Multiple third pixels and multiple third pixel circuits for driving the multiple third pixels may be arranged in the camera area 604 so that an image is displayed in the camera area 604 also. The multiple third pixel circuits may include oxide TFTs.

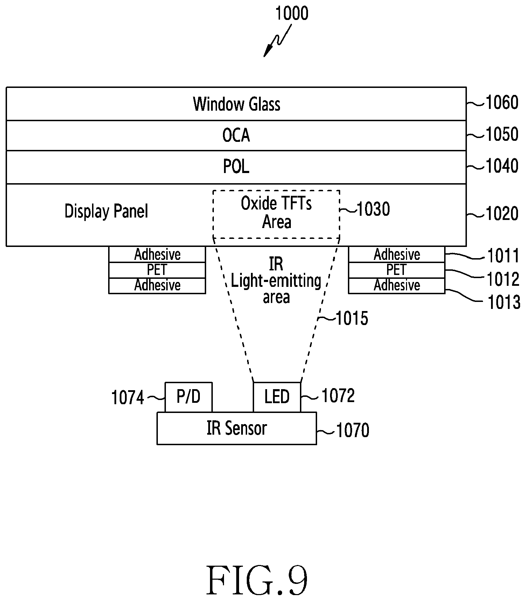

FIG. 9 is a view showing that a proximity sensor (e.g., an IR sensor 1070) is applied to an electronic device 1000 according to various embodiments of the disclosure.

Referring to FIG. 9, an electronic device 1000 may include a proximity sensor 1070 (e.g., an IR sensor), a display panel 1020, a polarization layer (POL) 1040, an adhesive layer (OCA) 1050, and a window glass 1060.

As one embodiment, the polarization layer (POL) 1040 may be disposed on the display panel 1020. The adhesive layer (OCA) 1050 may be disposed on the polarization layer (POL) 1040. The window glass 1060 may be disposed on the adhesive layer (OCA) 1050.

As one embodiment, at least a part of the display panel 1020, the polarization layer (POL) 1040, the adhesive layer (OCA) 1050, and/or the window glass 1060 may be included in the display device 160 in FIG. 1, the display 10 in FIG. 2, or the display 400 in FIG. 5. As one embodiment, the window glass 1060 may be included in the front plate 202 in FIG. 3 or the front plate 320 in FIG. 5.

As one embodiment, a layer (e.g., the PET layer 1012, or the adhesive layer 1011 or 1013) on the rear surface of the display panel 1020 may have an opening portion in which the proximity sensor 1070 (e.g., an IR sensor) is disposed. For example, a layer on the rear surface of the display panel 1020, which corresponds to a light-emitting area 1015 to which light emitted from an LED 1072 of the proximity sensor 1070 is emitted, may be perforated. For example, the PET layer 1012 may be a cushion layer, and may absorb at least a portion of an external force applied to the display panel 1020. An opening may be formed through at least a part of the PET layer 1012 in order to dispose the proximity sensor 1070. In another embodiment, for example, the PET layer 1012 may be formed of a sponge or a rubber material having elasticity. A first adhesive layer 1011 may be disposed on the upper part of the PET layer 1012, and a second adhesive layer 1013 may be disposed on the lower part of the PET layer 1012.

The first adhesive layer 1011, the PET layer 1012, and the second adhesive layer 1013 may be attached to the lower part of the display panel 1020. It may be possible to prevent light generated from the LED 1072 from being directly introduced into a photodiode (PD) 1074 by the first adhesive layer 1011, the PET layer 1012, and the second adhesive layer 1013.

The proximity sensor 1070 may be disposed under the display panel 1020 while having a predetermined interval. The proximity sensor 1070 may include the LED 1072 emitting light toward the display panel 1020 and the photodiode (PD) 1704 receiving light.

As one embodiment, a layer (e.g., the PET layer 1012, the first adhesive layer 1011, or the second adhesive layer 1013) on the rear surface of the display panel 1020 may have a portion which corresponds the LED 1072 of the proximity sensor 1070 and is perforated.

As one embodiment, a portion of the PET layer 1012, the first adhesive layer 1011, and the second adhesive layer 1013, which correspond to the light-emitting area 1015 of the LED 1702, may be perforated.

As one embodiment, a layer (e.g., the PET layer 1012, the first adhesive layer 1011, or the second adhesive layer 1013) on the rear surface of the display panel may have a portion which corresponds the photodiode 1074 of the proximity sensor 1070 and is perforated.

As one embodiment, in order to prevent a leakage current from occurring in TFTs positioned in a pixel circuit when external light is incident and the LED 1072 of the proximity sensor 1070 emits light, oxide TFTs, which have a relatively high energy band gap, may be arranged in a second pixel circuit (e.g., the second pixel circuit 722 in FIG. 8B) positioned in the sensor area 1030 (e.g., the proximity sensor area 602 or the fingerprint sensor area 603 in FIG. 6) according to an arrangement of the proximity sensor 1070. Here, a range of the sensor area 1030 may be set in consideration of the light-emitting area 1015 of the proximity sensor 1070.

As one embodiment, a range of the sensor area 1030 may be formed based on the light-emitting area 1015 of the proximity sensor 1070. The light-emitting area 1015 of the proximity sensor 1070 may be an area in which light substantially reaches as the LED 1072 emits light. As an example, the light-emitting area 1015 may also be an area through which light passes as a luminous body emits light on the display panel 1020.

For example, the sensor area 1030 may be formed narrower or wider than the light-emitting area 1015. As one embodiment, the sensor area 1030 may be formed to have a range wider than the light-emitting area 1015 of the proximity sensor 810.

As one embodiment, second pixel circuits (e.g., the second pixel circuit 722 in FIG. 8B) in the sensor area 1030 of the display panel 1020 may include oxide TFTs having a high energy band gap of 2.5 - 5.0 [eV].

As another embodiment, first pixel circuits (e.g., the first pixel circuit 712 in FIG. 8A) in the display area (e.g., the display area 610 in FIG. 6) except the sensor area 1030 may include LTPS TFTs having an energy band gap of 1.10 - 1.20 [eV].

As one embodiment, sunlight generates a photoelectric effect of about 1.10 - 2.50 [eV]. Therefore, when an oxide TFT having an energy band gap of 2.5 - 5.0 [eV] is disposed in the second pixel circuit in the sensor area 1030 of the display panel 1020, it may be possible to prevent the occurrence of a leakage current caused by external light.

As one embodiment, second pixel circuits in the sensor area 1030 of the display panel 1020 may include oxide TFTs (e.g., an IGZO TFT) (e.g., the oxide TFT 920 in FIG. 10A) including an IGZO active layer (e.g., the active layer 921 in FIG. 10A) including indium (In), gallium (Ga), zinc (Zo), and oxygen (O) having an energy band gap of 3.10 - 3.50 [eV].

The active layer (e.g., the active layer 921 in FIG. 10A) of an oxide TFT (e.g., the oxide TFT 920 in FIG. 10A) may be a layer formed to allow a current to flow on a substrate (e.g., glass or polyimide) (e.g., the substrate 902 in FIG. 10A), and a gate (e.g., the gate 922 in FIG. 10A), a source, and a drain (e.g., the source/drain 923 in FIG. 10A), which are an electrode, may be formed on the active layer.

As one embodiment, pixel circuits in the sensor area 1030 of the display panel 1020 may include ITZO TFTs including an active layer of an indium tin zinc oxide (ITZO) having an energy band gap of 3.10 - 3.50 [eV]. The ITZO TFT may include indium, tin, zinc, and oxygen.

Without being limited thereto, TFTs including an active layer having an energy band gap of 2.5 - 5.0 [eV] may be applied to a pixel circuit in the sensor area 1030 of the display panel 1020.

FIG. 10A is a view 900 showing a cross-sectional structure of a display panel (e.g., the display panel 1020 in FIG. 9) on which a top gate type oxide TFT 920 is disposed.

Referring to FIG. 9 and FIG. 10A, an oxide TFT 920 (e.g., an IGZO TFT or an ITZO TFT) may be applied to TFTs T1 - T8 of a second pixel circuit (e.g., the second pixel circuit 722 in FIG. 8B) positioned in the sensor area 1030 of the display panel 1020. The oxide TFT 920 (e.g., an IGZO TFT or an ITZO TFT) may be formed in a top gate manner.

As one embodiment, a buffer layer 904 may be disposed on the substrate 902 (e.g., glass). An active layer 921 including an oxide (e.g., IGZO or ITZO) may be disposed on the buffer layer 940. A gate insulating layer (GI) 906 may be disposed to cover the active layer 921. A gate 922 may be disposed on the gate insulating layer 906. An interlayer dielectric (ILD) 908 may be disposed to cover the gate 922. A source/drain (SD) 923 may be disposed on the interlayer dielectric 908. The source 923 may be disposed on one side on the interlayer dielectric 908, and the drain 923 may be disposed on the other side. The active layer 921 and the source/drain 923 may be electrically connected through a contact passing through the gate insulating layer 906 and the interlayer dielectric 908. Through this, the oxide TFT 920 may be formed. The planarization layer 910 may be disposed to cover the source/drain 923 of the oxide TFT 920. An anode electrode 912 of an OLED may be disposed on the planarization layer 910. The anode electrode 912 may be formed of a transparent conductive material (e.g., an indium tin oxide (ITO)). The drain 923 of the oxide TFT 920 and the anode electrode 912 of the OLED may be electrically connected through a contact CNT passing through the planarization layer 910. An LTPS TFT (not shown) may be formed in a top gate manner, identically or similarly to the oxide TFT 920 (e.g., an IGZO TFT or an ITZO TFT).

FIG. 10B is a view showing a cross-sectional structure 900-1 of a display panel (e.g., the display panel 1020 in FIG. 9) on which a bottom gate type oxide TFT 920-1 is disposed.

Referring to FIG. 9 and FIG. 10B, an oxide TFT 920-1 (e.g., an IGZO TFT or an ITZO TFT) may be applied to TFTs T1 - T8 of a second pixel circuit (e.g., the second pixel circuit 722 in FIG. 8B) positioned in the sensor area 1030 of the display panel 1020. The oxide TFT 920-1 (e.g., an IGZO TFT or an ITZO TFT) may be formed in a bottom gate manner.

As one embodiment, a buffer layer 904-1 may be disposed on the substrate 902-1 (e.g., glass). A gate insulating layer (GI) 906-1 may be disposed on the buffer layer 940-1. A gate 922- may be disposed on the gate insulating layer 906-1. An interlayer dielectric 908-1 may be disposed to cover the gate 922-1. An active layer 921-1 including an oxide (e.g., IGZO or ITZO) may be disposed on the interlayer dielectric 908-1. A source/drain (SD) 923-1, which is electrically connected to the active layer 921-1, may be disposed. A source may be disposed on one side of the interlayer dielectric 908-1, and a drain may be disposed on the other side. Through this, the oxide TFT 920-1 may be formed. A protective film 909-1 may be disposed to cover the active layer 921-1 and the source/drain (SD) 923-1. A planarization layer 910-1 may be disposed on the protective film 909-1. An anode electrode 912-1 of an OLED may be disposed on the planarization layer 910-1. The anode electrode 912-1 may be formed of a transparent conductive material (e.g., an ITO). The drain of the oxide TFT 920-1 and the anode electrode 912-1 of the OLED may be electrically connected through a contact CNT passing through the protective film 909-1 and the planarization layer 910-1. An LTPS TFT (not shown) may be formed in a bottom gate manner, identically or similarly to the oxide TFT 920-1 (e.g., an IGZO TFT or an ITZO TFT).

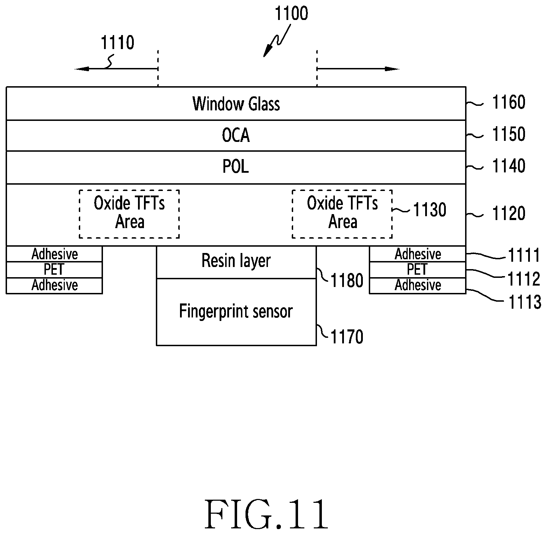

FIG. 11 is a view showing that a fingerprint sensor 1170 is applied to an electronic device 1100 according to various embodiments of the disclosure.

Referring to FIG. 11, an electronic device 1100 according to various embodiments of the disclosure may include a fingerprint sensor 1170, a display panel 1120, a polarization layer (POL) 1140, an adhesive layer (OCA) 1150, and a window glass 1160.

According to various embodiments of the disclosure, the fingerprint sensor 1170 may be disposed under the display panel 1120. A resin layer 1180 may be disposed between the display panel 1120 and the fingerprint sensor 1170. The polarization layer (POL) 1140 may be disposed on the display panel 1120. The adhesive layer (OCA) 1150 may be disposed on the polarization layer (POL) 1140. The window glass 1160 may be disposed on the adhesive layer (OCA) 1150.

As one embodiment, a layer (e.g., the PET layer 1112, the first adhesive layer 1111, or the second adhesive layer 1113) on the rear surface of the display panel 1120 may have a portion in which the fingerprint sensor 1170 is disposed and which is perforated. For example, the PET layer 1112 layer may be a cushion layer, and may absorb at least a portion of an external force applied to the display panel 1120. In another embodiment, for example, the PET layer 1112 may be formed of a sponge or a rubber material having elasticity. A first adhesive layer 1111 may be disposed on the upper part of the PET layer 1112, and a second adhesive layer 1113 may be disposed on the lower part of the PET layer 1112.

As one embodiment, when external light (e.g., sunlight) is incident, a leakage current may occur in the TFTs in the sensor area 1130. In order to prevent a leakage current from occurring in the TFTs in the sensor area 1130, oxide TFTs having a relatively higher energy band gap than an LTPS TFT may be arranged in the sensor area 1130 of the display panel 1120 according to an arrangement of the fingerprint sensor 1170. Here, the sensor area 1130 may be formed around the display area 1110 and around the fingerprint sensor 1170.

As one embodiment, when at least a part of the display area 1110 around the fingerprint sensor 1170 emits light, a leakage current may occur in the TFTs in the sensor area 1130. In order to prevent a leakage current from occurring in the TFTs in the sensor area 1130, oxide TFTs having a relatively higher energy band gap than an LTPS TFT may be arranged in the sensor area 1130 of the display panel 1120 according to an arrangement of the fingerprint sensor 1170. Here, the sensor area 1130 may be formed around the display area 1110 and around the fingerprint sensor 1170.

As one embodiment, when the fingerprint sensor 1170 includes an IR luminous body, when at least a part of the display area 1110 around the fingerprint sensor 1170 emits light due to the light emission of the IR luminous body, a leakage current may occur in the TFTs of the sensor area 1130. In order to prevent a leakage current from occurring in the TFTs in the sensor area 1130, oxide TFTs having a relatively higher energy band gap than an LTPS TFT may be arranged in the sensor area 1130 of the display panel 1120 according to an arrangement of the fingerprint sensor 1170. Here, the sensor area 1130 may be formed around the display area 1110 and around the fingerprint sensor 1170.

As one embodiment, a range of the sensor area 1130 may be set in consideration of an area of the fingerprint sensor 1170.

As one embodiment, since the resin layer 1180 is disposed on the fingerprint sensor 1170, an LTPS TFT may be disposed in a portion of the display panel 1120, at which the fingerprint sensor 1170 and the resin layer 1180 overlap.

As one embodiment, the sensor area 1130 may be positioned in an area of the display panel 1120, which corresponds to between the PET layer 1112, and the edge portion of the fingerprint sensor 1170 and the resin layer 1180. Here, the sensor area 1130 may also be positioned in an area of the display panel 1120, which overlaps the PET layer 1112.

When the fingerprint sensor 1170 includes an IR luminous body, the sensor area 1130 may be formed to have a range wider outside the fingerprint sensor 1170 in consideration of a position in which the fingerprint sensor 1170 is disposed. As one embodiment, pixel circuits (e.g., the second pixel circuit 722 in FIG. 8B) in the sensor area 1130 of display panel 1120 may include oxide TFTs having a high energy band gap of 2.5 - 5.0 [eV]. On the other hand, pixel circuits (e.g., the first pixel circuit 712 in FIG. 8A) in the display area 1110 except the sensor area 1130 may include LTPS TFTs having an energy band gap of 1.10 - 1.20 [eV].

As one embodiment, when an oxide TFT having an energy band gap of 2.5 - 5.0 [eV] is disposed in a pixel circuit (e.g., the second pixel circuit 722 in FIG. 8B) in the sensor area 1130, it may be possible to prevent the occurrence of a leakage current of the TFT by external light.

As one embodiment, pixel circuits (e.g., the second pixel circuit 722 in FIG. 8B) in the sensor area 1130 of the display panel 1120 may include IGZO TFTs including an IGZO active layer including indium (In), gallium (Ga), zinc (Zo), and oxygen (O) having an energy band gap of 3.10 - 3.50 [eV].

As one embodiment, pixel circuits (e.g., the second pixel circuit 722 in FIG. 8B) in the sensor area 1130 of the display panel 1120 may include ITZO TFTs including an active layer of an indium tin zinc oxide (ITZO) having an energy band gap of 3.10 - 3.50 [eV].

Without being limited thereto, TFTs including an active layer having an energy band gap of 2.5 - 5.0 [eV] may be applied to the pixel circuit (e.g., the second pixel circuit 722 in FIG. 8B) in the sensor area 1130 of the display panel 1120.

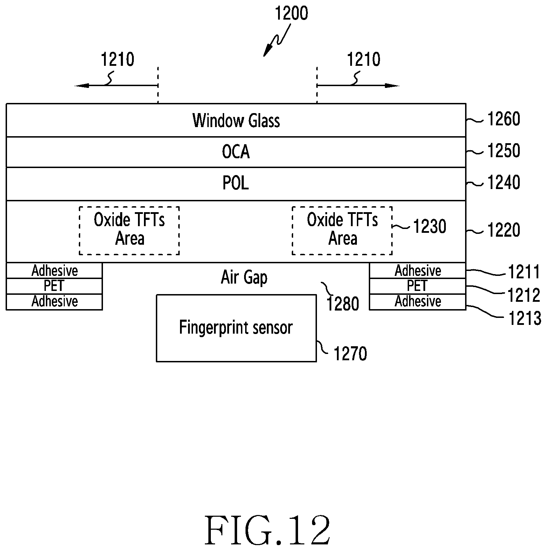

FIG. 12 is a view showing that a fingerprint sensor 1270 is applied to an electronic device 1200 according to various embodiments of the disclosure.

Referring to FIG. 12, an electronic device 1200 may include a fingerprint sensor 1270, a display panel 1220, a polarization layer (POL) 1240, an adhesive layer (OCA) 1250, and a window glass 1260.

The fingerprint sensor 1270 may be disposed under the display panel 1220. An air gap 1280 may be formed between the display panel 1220 and the fingerprint sensor 1270. The polarization layer (POL) 1240 may be disposed on the display panel 1220. The adhesive layer (OCA) 1250 may be disposed on the polarization layer (POL) 1240. The window glass 1260 may be disposed on the adhesive layer (OCA) 1250.

As one embodiment, a layer (e.g., the PET layer 1212, the first adhesive layer 1211, or the second adhesive layer 1213) on the rear surface of the display panel 1220 may have a portion in which the fingerprint sensor 1270 is disposed and is perforated. For example, the PET layer 1212 layer may be a cushion layer, and may absorb at least a portion of an external force applied to the display panel 1220. In another embodiment, for example, the PET layer 1212 may be formed of a sponge or a rubber material having elasticity. The first adhesive layer 1211, the PET layer 1212, and the second adhesive layer 1213 may be attached to the lower part of the display panel 1220. A first adhesive layer 1211 may be disposed on the upper part of the PET layer 1212, and a second adhesive layer 1213 may be disposed on the lower part of the PET layer 1212.

External light is reflected by the fingerprint sensor 1270 and/or the air gap 1280 to make a leakage current flow in the LTPS TFTs of the pixel circuit (e.g., the first pixel circuit 712 in FIG. 8A) around the fingerprint sensor 1270, and thus the OLED of the corresponding pixel may unintentionally emit light. As one embodiment, it may be possible to prevent or reduce external light from being reflected by the fingerprint sensor 1270 and/or the air gap 1280 by using the first adhesive layer 1211, the PET layer 1212, and the second adhesive layer 1213. As one embodiment, the PET layer 1212 may be disposed around the fingerprint sensor 1270 to prevent external light from being reflected by the fingerprint sensor 1270 and/or the air gap 1280. It may be possible to prevent a leakage current from occurring in the TFT by preventing external light from being reflected by the air gap 1280.

As one embodiment, when the fingerprint sensor 1270 includes an IR luminous body, a range of the sensor area 1230 may be formed according to an arrangement of the fingerprint sensor 1170. As one embodiment, a range of the sensor area 1270 may be formed wider outside the fingerprint sensor 1270. For example, the sensor area 1270 may be formed to have a range wider than the area of the fingerprint sensor 1270.

As one embodiment, the sensor area 1230 may be positioned between the display area 1210 and an area corresponding to the fingerprint sensor 1270. In this case, the sensor area 1230 may be positioned to partially overlap an area corresponding to the fingerprint sensor 1270.

Pixel circuits (e.g., the second pixel circuit 722 in FIG. 8B) in the sensor area 1230 of the display panel 1220 may include oxide TFTs having a high energy band gap of 2.5 - 5.0 [eV]. According to another embodiment, pixel circuits (e.g., the first pixel circuit 712 in FIG. 8A) in the display area 1210 except the sensor area 1230 may include LTPS TFTs having an energy band gap of 1.10 - 1.20 [eV].

When an oxide TFT having an energy band gap of 2.5 - 5.0 [eV] is disposed in the pixel circuit in the sensor area 1230, it may be possible to prevent the occurrence of a leakage current caused by external light.

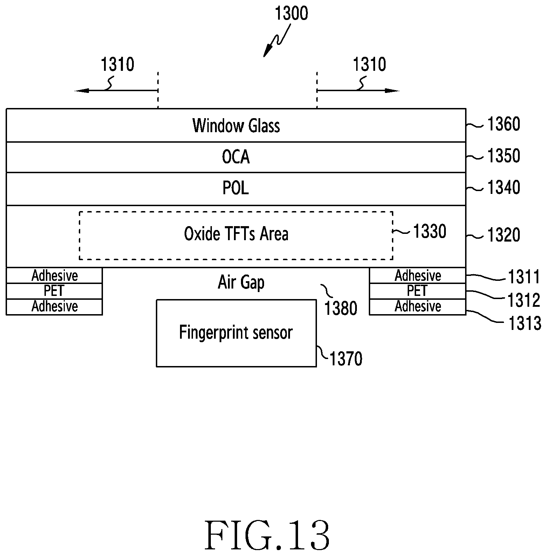

FIG. 13 is a view showing that a fingerprint sensor is applied to an electronic device according to various embodiments of the disclosure.

Referring to FIG. 13, an electronic device 1300 may include a fingerprint sensor 1370, a display panel 3220, a polarization layer (POL) 1340, an adhesive layer (OCA) 1350, and a window glass 1360.

The fingerprint sensor 1370 may be disposed under the display panel 1320. An air gap 1380 may be formed between the display panel 1320 and the fingerprint sensor 1370. The polarization layer 1340 may be disposed on the display panel 1320. The adhesive layer 1350 may be disposed on the polarization layer 1340. The window glass 1360 may be disposed on the adhesive layer 1350.

As one embodiment, a layer (e.g., the PET layer 1312, the first adhesive layer 1311, or the second adhesive layer 1313) on the rear surface of the display panel 1320 may have a portion in which the fingerprint sensor 1370 is disposed and is perforated. For example, the PET layer 1312 layer may be a cushion layer, and may absorb at least a portion of an external force applied to the display panel 1320. In another embodiment, for example, the PET layer 1312 may be formed of a sponge or a rubber material having elasticity. A first adhesive layer 1311 may be disposed on the upper part of the PET layer 1312, and a second adhesive layer 1313 may be disposed on the lower part of the PET layer 1312.

External light is reflected by the fingerprint sensor 1370 and/or the air gap 1380 to make a leakage current flow in the LTPS TFTs of the pixel circuit (e.g., the first pixel circuit 712 in FIG. 8A) around the fingerprint sensor 1370, and thus the OLED of the corresponding pixel may unintentionally emit light. As one embodiment, the PET layer 1312 may be disposed around the fingerprint sensor 1370 to prevent external light from being reflected by the fingerprint sensor 1370 and/or the air gap 1380. It may be possible to prevent a leakage current from occurring in the TFT by preventing external light from being reflected by the air gap 1380.

As one embodiment, a range of the sensor area 1330 may be formed according to an arrangement of the fingerprint sensor 1370. As one embodiment, a range of the sensor area 1370 may be formed wider outside the fingerprint sensor 1330. For example, the sensor area 1370 may be formed to have a range wider than the area of the fingerprint sensor 1330.

As one embodiment, when the fingerprint sensor 1370 is seen from the outside of the display panel 1320, the sensor area 1330 according to an arrangement of the fingerprint sensor 1370 may be positioned such that the sensor area 1330 overlaps all areas of the fingerprint sensor 1370.

Pixel circuits (e.g., the second pixel circuit 722 in FIG. 8B) in the sensor area 1330 of display panel 1320 may include oxide TFTs having a high energy band gap of 2.5 - 5.0 [eV]. According to another embodiment, pixel circuits (e.g., the first pixel circuit 712 in FIG. 8A) in the display area 1310 except the sensor area 1330 may include LTPS TFTs having an energy band gap of 1.10 - 1.20 [eV].

When an oxide TFT having an energy band gap of 2.5 - 5.0 [eV] is disposed in the pixel circuit in the sensor area 1330, it may be possible to prevent the occurrence of a leakage current caused by external light.

As one embodiment, pixel circuits in the sensor area 1230 or 1330 of the display panel 1220 or 1320 may include IGZO TFTs including an IGZO active layer including indium (In), gallium (Ga), zinc (Zo), and oxygen (O) having an energy band gap of 3.10 - 3.50 [eV].

As one embodiment, pixel circuits in the sensor area 1230 or 1330 of the display panel 1220 or 1320 may include ITZO TFTs including an active layer of an indium tin zinc oxide (ITZO) having an energy band gap of 3.10 - 3.50 [eV].

Without being limited thereto, TFTs including an active layer having an energy band gap of 2.5 - 5.0 [eV] may be applied to the pixel circuit in the sensor area 1230 or 1330 of the display panel 1220 or 1320.

As one embodiment, when a camera is disposed in the camera area 604 illustrated in FIG. 6 in an under-display camera (UDC) manner, an oxide TFT having an energy band gap of 2.5 - 5.0 [eV] may be disposed in the pixel circuit in the camera area 604.

When an oxide TFT having an energy band gap of 2.5 - 5.0 [eV] is disposed in the pixel circuit in the camera area 604, it may be possible to prevent the occurrence of a leakage current caused by external light.

As one embodiment, pixel circuits in the camera area 604 may include IGZO TFTs including an IGZO active layer including indium (In), gallium (Ga), zinc (Zo), and oxygen (O) having an energy band gap of 3.10 - 3.50 [eV].

As one embodiment, pixel circuits in the camera area 604 may include ITZO TFTs including active layer of an indium tin zinc oxide (ITZO) having an energy band gap of 3.10 - 3.50 [eV].

Without being limited thereto, TFTs including an active layer having an energy band gap of 2.5 - 5.0 [eV] may be applied to the pixel circuit in the camera area 604.

According to various embodiments of the disclosure, a drive circuit part for driving a sensor and in a portion in which a photoelectric effect is generated according to external light may be formed by an oxide TFT having a high energy band gap of 2.5 - 5.0 [eV] so as to prevent the occurrence of a leakage current. It may be possible to prevent unintended light emission of the OLED and a brightness change of the OLED by preventing a leakage current from flowing in TFTs of the drive circuit part.

The electronic device 200 or 600 according to various embodiments of the disclosure may include a display panel 610, 1120, 1220, or 1320 and a sensor 180, 205, 500, 1070, 1170, 1270, or 1370. The display panel 610, 1120, 1220, or 1320 may be disposed in an inner space of the housing 210 to be visible from the outside. The sensor 180, 205, 500, 1070, 1170, 1270, or 1370 may be positioned under the display panel 610, 1120, 1220, or 1320. The display panel 610, 1120, 1220, or 1320 may include a first area 601 and a second area 602, 603, and 604 according to an arrangement of the sensor 180, 205, 500, 1070, 1170, 1270, or 1370. The display panel 610, 1120, 1220, or 1320 may include a first pixel circuit 712 configured to drive a first pixel 611 disposed in the first area 601, and a second pixel circuit 722 configured to drive a second pixel 621 disposed in the second area 602, 603, and 604. At least a part of multiple first switching elements T1a - T7a included in the first pixel circuit 712, and multiple second switching elements T1b - T7b included in the second pixel circuit 722 may have different energy band gaps.

In the electronic device 200 or 600, an entirety of the multiple first switching elements T1a - T7a and an entirety of the multiple second switching elements T1b - T7b may have different energy band gaps.

In the electronic device 200 or 600, at least a part of the multiple first switching elements T1a - T7a and at least a part of the multiple second switching elements T1b - T7b may have the same energy band gap.

In the electronic device 200 or 600, an energy band gap of the multiple second switching elements T1b - T7b may be higher than an energy band gap of a part or an entirety of the multiple first switching elements T1a - T7a.

In the electronic device 200 or 600, at least one of the multiple first switching elements T1a - T7a may be a low-temperature polycrystalline silicon (LTPS) thin film transistor (TFT), and the multiple second switching elements T1b - T7b may be an oxide TFT.

In the electronic device 200 or 600, at least n switching elements among the multiple first switching elements T1a - T7a may be oxide TFTs, and the multiple second switching elements T1b - T7b may include m oxide TFTs, wherein m is larger than n.

In the electronic device 200 or 600, the oxide TFT may have an energy band gap of 2.5 - 5.0 [eV].

In the electronic device 200 or 600, the oxide TFT may be an IGZO oxide TFT including indium (In), gallium (Ga), zinc (Zo), and oxygen (O).

In the electronic device 200 or 600, at least two of the multiple first switching elements T1a - T7a may be oxide TFTs, and at least seven of the multiple second switching elements T1b - T7b may be oxide TFTs.

In the electronic device 200 or 600, the second area 602, 603, and 604 may be formed to have a range wider than the sensor 180, 205, 500, 1070, 1170, 1270, or 1370.

In the electronic device 200 or 600, the sensor 180, 205, 500, 1070, 1170, 1270, or 1370 may include one or more of a proximity sensor 1070, a fingerprint sensor 1170, 1270, or 1370, and an image sensor 180, 205, or 500.

In the electronic device 200 or 600, the second area 602, 603, and 604 may include one or more of a proximity sensor area 602 in which the proximity sensor 1070 is disposed, a fingerprint sensor area 603 in which the fingerprint sensor 1170, 1270, or 1370 is disposed, and a camera area 604 in which the image sensor 180, 205, or 500 is disposed.

In the electronic device 200 or 600, a resin layer 1180 may be disposed between the display panel 610, 1120, 1220, or 1320 and the proximity sensor 1070, a resin layer 1180 may be disposed between the display panel 610, 1120, 1220, or 1320 and the fingerprint sensor 1170, 1270, or 1370, or a resin layer 1180 may be disposed between the display panel 610, 1120, 1220, or 1320 and the image sensor 180, 205, or 500.

In the electronic device 200 or 600, an air gap 1280 or 1380 may be formed between the display panel 610, 1120, 1220, or 1320 and the proximity sensor 1070, an air gap 1280 or 1380 may be formed between the display panel and the fingerprint sensor 1170, 1270, or 1370, or an air gap 1280 or 1380 may be formed between the display panel 610, 1120, 1220, or 1320 and the image sensor 180, 205, or 500.

The electronic device 200 or 600 may include a first gate driver circuit 620, a second gate driver circuit 630, and a driver controller 640. The first gate driver circuit 620 may be configured to drive a first pixel 611 disposed in the first area 601 of the display panel 610, 1120, 1220, or 1320. The second gate driver circuit 630 may be configured to drive a second pixel 621 disposed in the second area 602, 603, and 604. The driver controller 640 may be configured to supply a first gate control signal to the first gate driver circuit 620 and supply a second gate control signal to the second gate driver circuit 630.

In the electronic device 200 or 600, the first gate driver circuit 620 may be configured to generate first shift register signals based on the first gate control signal and to supply the first shift register signals to the first pixel circuit 712. The second gate driver circuit 630 may be configured to generate second shift register signals based on the second gate control signal and to supply the second shift register signals to the second pixel circuit 722.

The electronic device 200 or 600 according to various embodiments of the disclosure may include a display panel 610, 1120, 1220, or 1320, multiple sensors 180, 205, 500, 1070, 1170, 1270, and 1370, and a driving part 605. The display panel 610, 1120, 1220, or 1320 may be disposed in an inner space of the housing 210 to be visible from the outside, and may include a first area 601 and multiple second areas 602, 603, and 604 except for the first area 601. The multiple sensors 180, 205, 500, 1070, 1170, 1270, and 1370 may be positioned under the multiple second areas 602, 603, and 604. The driving part 605 may be configured to drive the display panel 610, 1120, 1220, or 1320.

In the electronic device 200 or 600, the multiple sensors 180, 205, 500, 1070, 1170, 1270, and 1370 may include at least one sensor 180, 205, 500, 1070, 1170, 1270, or 1370 positioned under the display panel 610, 1120, 1220, or 1320. The display panel 610, 1120, 1220, or 1320 may include multiple first switching elements T1a - T7a included in multiple first pixel circuits 721 arranged in the first area 601, and multiple second switching elements T1b - T7b included in multiple second pixel circuits 722 arranged in the multiple second areas 602, 603, and 604. The multiple first switching elements T1a - T7a may include different types of switching elements having different energy band gaps. The multiple second switching elements T1b - T7b may include the same type of a switching element having the same energy band gap.

In the electronic device 200 or 600, at least a part of the multiple first switching elements T1a - T7a included in the first pixel circuit 712, and multiple second switching elements T1b - T7b included in the second pixel circuit 722 may have different energy band gaps.

In the electronic device 200 or 600, an energy band gap of the multiple second switching elements T1b - T7b may be higher than an energy band gap of a part or an entirety of the multiple first switching elements T1a - T7a.

In the electronic device 200 or 600, at least one of the multiple first switching elements T1a - T7a may be a low-temperature polycrystalline silicon (LTPS) thin film transistor (TFT), and the multiple second switching elements T1b - T7b may be oxide TFTs.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a display panel disposed in an inner space of a housing, the display panel to be visible from the outside; and
a sensor positioned under the display panel,
wherein the display panel comprises a first area and a second area according to an arrangement of the sensor,
the display panel comprises a first pixel circuit configured to drive a first pixel disposed in the first area, and a second pixel circuit configured to drive a second pixel disposed in the second area,
at least a part of multiple first switching elements included in the first pixel circuit have an energy band gap different from an energy band gap of multiple second switching elements included in the second pixel circuit.

2. The electronic device of claim 1, wherein an entirety of the multiple first switching elements have an energy band gap different from an energy band gap of an entirety of the multiple second switching elements.

3. The electronic device of claim 1, wherein at least a part of the multiple first switching elements and at least a part of the multiple second switching elements have an identical energy band gap.

4. The electronic device of claim 1, wherein the energy band gap of the multiple second switching elements is higher than an energy band gap of a part or an entirety of the multiple first switching elements.

5. The electronic device of claim 1, wherein at least one of the multiple first switching elements is a low-temperature polycrystalline silicon (LTPS) thin film transistor (TFT), and
the multiple second switching elements are oxide TFTs.

6. The electronic device of claim 1, wherein the multiple first switching elements comprise at least n oxide TFTs, and
the multiple second switching elements comprise m oxide TFTs, wherein m is larger than n.

7. The electronic device of claim 6, wherein the oxide TFT has an energy band gap of 2.5 - 5.0 [eV].

8. The electronic device of claim 6, wherein the oxide TFT is an IGZO oxide TFT comprising indium (In), gallium (Ga), zinc (Zo), and oxygen (O).

9. The electronic device of claim 6, wherein at least two of the multiple first switching elements are oxide TFTs, and
at least seven of the multiple second switching elements are oxide TFTs.

10. The electronic device of claim 1, wherein the second area is formed to have a range wider than the sensor.

11. The electronic device of claim 10, wherein the sensor comprises one or more of a proximity sensor, a fingerprint sensor, and an image sensor.

12. The electronic device of claim 11, wherein the second area comprises at least one of a proximity sensor area in which the proximity sensor is disposed, a fingerprint sensor area in which the fingerprint sensor is disposed, and a camera area in which the image sensor is disposed.

13. The electronic device of claim 11, wherein a resin layer is disposed between the display panel and the proximity sensor, a resin layer is disposed between the display panel and the fingerprint sensor, or a resin layer is disposed between the display panel and the image sensor.

14. The electronic device of claim 11, wherein an air gap is formed between the display panel and the proximity sensor, an air gap is formed between the display panel and the fingerprint sensor, or an air gap is formed between the display panel and the image sensor.

15. The electronic device of claim 1, comprising:
a first gate driver circuit configured to drive the first pixel disposed in the first area of the display panel;
a second gate driver circuit configured to drive the second pixel disposed in the second area; and
a driver controller configured to supply a first gate control signal to the first gate driver circuit and to supply a second gate control signal to the second gate driver circuit.
